Europäisches Patentamt

European Patent Office

Office européen des brevets

(11) Veröffentlichungsnummer: **0 228 516 B1**

## (12) EUROPÄISCHE PATENTSCHRIFT

(45) Veröffentlichungstag der Patentschrift: 26.06.91

(21) Anmeldenummer: 86114171.1

(22) Anmeldetag: 14.10.86

(51) Int. Cl.5: **H01L 29/10, H01L 29/36, H01L 29/812**

(54) Modulationsdotierter Feldeffekttransistor.

(30) Priorität: 30.11.85 DE 3542482

(43) Veröffentlichungstag der Anmeldung:
15.07.87 Patentblatt 87/29

(45) Bekanntmachung des Hinweises auf die
Patenterteilung:
26.06.91 Patentblatt 91/26

(84) Benannte Vertragsstaaten:
DE FR GB

(56) Entgegenhaltungen:

CHEMICAL ABSTRACTS, Band 103, 4. November 1985, Seite 675, Zusammenfassung Nr. 151817t, Columbus, Ohio, US; T.P. PEARSALL et al.: "Germanium-silicon alloy modulation-doped P-channel field-effect transistors", & PROC. - ELECTROCHEM. SOC. 1985, 85-7(Silicon Mol. Beam Epitaxy) 400-405

(73) Patentinhaber: **Licentia Patent-Verwaltungs-GmbH**
**Theodor-Stern-Kai 1**
**W-6000 Frankfurt/Main 70(DE)**

(72) Erfinder: **Dämbkes, Heinrich, Dr.-Ing.**
**Stäudlenweg 29**
**W-7900 Ulm(DE)**
Erfinder: **Herzog, Hans J., Dipl.-Phys.**
**Stauffenbergstrasse 18**
**W-7910 Neu-Ulm 4(DE)**
Erfinder: **Jorke, Helmut, Dipl.-Phys.**
**Böhmenstrasse 76**
**W-7929 Gerstetten(DE)**

(74) Vertreter: **Amersbach, Werner, Dipl.-Ing. et al**
**Licentia Patent-Verwaltungs-GmbH Theodor-Stern-Kai 1**
**W-6000 Frankfurt 70(DE)**

APPLIED PHYSICS LETTERS, Band 41, Nr. 5, 1. September 1982, Seiten 464-466, American Institute of Physics, New York, US; H.M. MANASEVIT et al.: "Electron mobility enhancement in epitaxial multilayer Si-Si1-xGex alloy films on (100) Si"

APPLIED PHYSICS LETTERS, Band 45, Nr. 11, 1. Dezember 1984, Seiten 1231-1233, American Institute of Physics, New York, US; R. PEOPLE et al.: "Modulation doping in GexSi1-x/Si strained layer heterostructures"

IEEE TRANSACTIONS ON ELECTRON DEVICES, Band ED-33, Nr. 5, Mai 1986, Seiten 633-638, New York, US; H. DAEMBKES et al.: "The n-channel SiGe/Si modulation-doped field-effect transistor"

**Beschreibung**

Die Erfindung betrifft einen modulationsdotierten Feldeffekttransistor nach dem Oberbegriff des Patentanspruchs 1.

Ein derartiger Transistor wird auch als MODFET bezeichnet und ist aus der Veröffentlichung von T.P. Pearsall et al. "$Ge_xSi_{1-x}$ modulation-doped p-channel field-effect transistor", Proc. 1st Intern. Symp. on Silicon MBE, Vol. 85-7, pp. 400-405, May 1985, Toronto, Canada; Ed. J.C. Bean, Elektrochem. Soc., Pennington, N.J. bekannt.

Der dort angegebene MODFET enthält eine Halbleiter-Schichtenfolge auf der Grundlage von Silizium (Si), welche den Aufbau eines MODFET's mit einem sogenannten p-leitenden Kanal ermöglicht. Für die meisten Schaltungsanwendungen sind jedoch Feldeffekttransistoren (FET's) erforderlich, die einen n-leitenden Kanal besitzen.

Der Erfindung liegt daher die Aufgabe zugrunde, einen gattungsgemäßen MODFET mit einer Halbleiter-Schichtenfolge anzugeben, welcher mindestens einen n-leitenden Kanal enthält.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein erster Vorteil der Erfindung besteht darin, daß eine hohe Ladungsträgerbeweglichkeit vorhanden ist, so daß ein Transistor mit einer hohen Grenzfrequenz herstellbar ist.

Ein zweiter Vorteil besteht darin, daß beim Betrieb des erfindungsgemäßen n-MODFET's eine elektrische Vorspannung des Substrates vermeidbar ist. Dadurch ist es möglich, eine Kontaktierung des Substrates von vornherein zu vermeiden, so daß die Herstellungskosten in vorteilhafter Weise erheblich verringert werden.

Die Erfindung beruht auf einem Heteroübergang einer $Si_{1-x}Ge_x$/Si-Halbleiterschichtenfolge, bei der ein zweidimensionales Ladungsträgergas entsteht. Dabei werden Elektronen im wesentlichen innerhalb der Si-Halbleiterschicht geführt.

Die Erfindung wird im folgenden anhand eines Ausführungsbeispiels näher erläutert unter Bezugnahme auf eine schematische Zeichnung.

Fig. 1    zeigt einen schematischen Querschnitt durch einen n-MODFET zur Erläuterung der Halbleiter-Schichtenfolge;

Fig. 2    zeigt eine schematische Darstellung des zugehörigen Bandschemas.

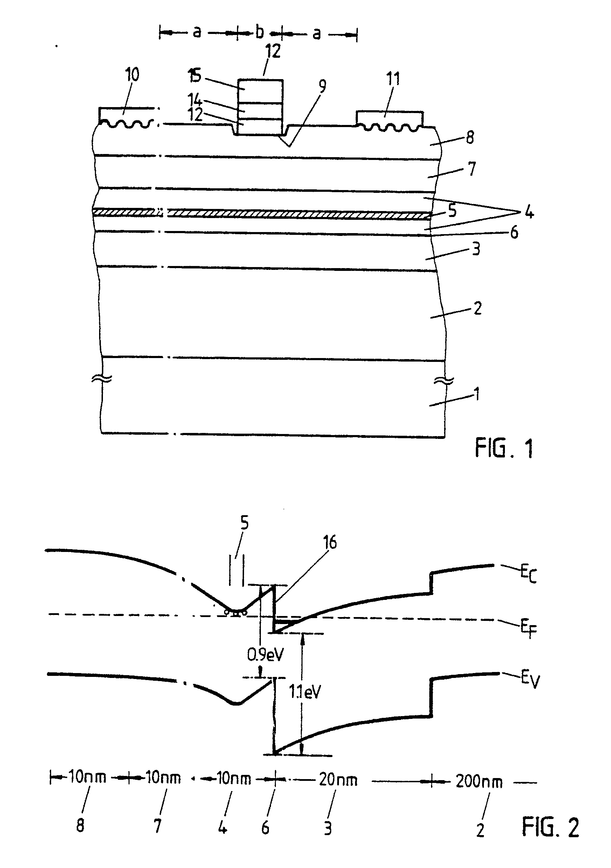

Fig. 1 zeigt ein Silizium(Si)-Substrat 1, z.B. eine Si-Scheibe mit einem Durchmesser von ungefähr 75 mm, einer Dicke von ungefähr 0,5 mm sowie einer (100)-Kristallorientierung. Das Si-Substrat 1 ist $p^-$-leitend und besitzt einen hohen spezifischen elektrischen Widerstand von ungefähr $10^4$ Ohm $\cdot$ cm. Durch diesen hohen spezifischen Widerstand werden vorteilhafterweise störende parasitäre elektrische Effekte vermieden, z.B. ein unerwünschter Strom durch das Substrat. Mit Hilfe einer Molekularstrahlepitaxie (MBE)-Anlage wird nun bei einer niedrigen Temperatur, z.B. 900 K, sowie einem Ultrahochvakuum von kleiner gleich 1-$10^{-9}$mbar die folgende Halbleiter-Schichtenfolge aufgewachsen:

Zunächst eine Pufferschicht 2 aus einer $Si_{0.75}Ge_{0.25}$ Legierung mit einer Schichtdicke von 0.2 $\mu$m. Diese Pufferschicht 2 bewirkt, daß Kristalldefekte (Fehlanpassungsversetzungen) im wesentlichen an der Grenzschicht Substrat-Pufferschicht lokalisiert sind und daß eine vorherbestimmbare mechanische Spannungsverteilung entsteht für die nachfolgend aufgebrachten Halbleiterschichten. Eine Einstellung dieser mechanischen Spannungsverteilung ist möglich durch Wahl der Zusammensetzung der SiGe-Legierung und/oder durch Wahl der Schichtdicke der Pufferschicht 2. Auf dieser Pufferschicht 2 wird nun eine Heterostruktur aufgewachsen, welche den n-leitenden Kanal bildet. Diese Heterostruktur enthält beispielsweise eine ungefähr 20 nm dicke undotierte Si-Schicht 3 sowie eine darauf angebrachte ungefähr 10 nm dicke $Si_{0.5}Ge_{0.5}$ Schicht 4, die eine räumlich begrenzte n-Dotierung 5 enthält, z.B. eine 2 nm dicke Antimon-(Sb)-Schicht. Dabei ist wichtig, daß eine Berührung der n-Dotierung 5 mit der Si-Schicht 3 vermieden wird. Bei den Schichten 3 und 4 sind die Schichtdicken jeweils so gewählt, daß diese unterhalb einer sogenannten kritischen Schichtdicke liegen. Dadurch ist auch in diesen Schichten eine vorhersehbare Einstellung der mechanischen Spannungsverteilung möglich. Auf die $Si_{0.5}Ge_{0.5}$ Schicht 4 wird nun eine ungefähr 10 nm dicke SiGe-Übergangsschicht 7 aufgebracht, deren Germanium(Ge)-Gehalt sich fortlaufend verringert. Der Ge-Gehalt ist am höchsten an der $Si_{0.5}Ge_{0.5}$ Schicht 4, er beträgt dort beispielsweise 50 Atomprozent, und ist am niedrigsten (ungefähr 0 Atomprozent) an der nachfolgend aufgebrachten ungefähr 10 nm dicken Kontaktierungsschicht 8, die aus undotiertem Silizium besteht. Auf dieser Si-Kontaktierungsschicht sind die für einen Feldeffekttransistor erforderlichen Kontakte angebracht. Dabei bestehen die Source- und Drainanschlüsse 10, 11 aus einer Gold(Au)-Antimon(Sb)-Legierung. Die Steuerelektrode 12, der sogenannte Gate-Anschluß, besitzt an der Kontaktierungsschicht 8 einen Schottky-Kontakt 9. Dieser entsteht beispielsweise dadurch, daß die Steuerelektrode 12 aus einer Platin(Pt)-Schicht 13, einer Titan(Ti)-Schicht 14 sowie einer Gold(Au)-Schicht 15 zusammengesetzt ist.

Die Steuerelektrode 12 hat eine beispielhafte Breite b von ungefähr 1,6 $\mu$m sowie eine beispielhafte Länge (senkrecht zur Zeichenebene) von ungefähr 160 µm. Der Abstand a zwischen Steuerelektrode 12 und Source- bzw. Drainelektrode 10, 11 beträgt ungefähr 1,5 µm. Der Abstand zwischen dem Schottky-Kontakt 9 und dem n-leitenden Kanal ist einstellbar durch eine Verringerung der Schichtdicke der Kontaktierungsschicht 8 im Bereich der Steuerelektrode 12. Dieser Vorgang erfolgt z.B. durch einen Ätzvorgang.

Fig. 2 zeigt das zu dem Ausführungsbeispiel gemäß Fig. 1 gehörende Energie-Bandschema. Dabei entsprechen die Bezugszeichen denjenigen der Fig. 1. Mit den Maßangaben, z.B. 20 nm, ist die Dicke der jeweiligen Schicht bezeichnet. Die mit $E_C$ bezeichnete Kurve bezieht sich auf das Leitungsband, $E_F$ bezeichnet das Fermi-Niveau und $E_V$ bezeichnet das Valenzband. Die Höhe des Leitungsbandsprunges 16 ist einstellbar durch den Ge-Anteil der Pufferschicht 2 und/oder den Ge-haltigen Halbleiterschichten, z.B. der Schicht 4, welche den n-leitenden Kanal erzeugen. Aus Fig. 2 ist ersichtlich, daß ein abnehmender Ge-Anteil in der Übergangsschicht 7 erforderlich ist, denn ansonsten würde zwischen den Schichten 7 und 8 ein weiterer, störender Leitungsbandsprung entstehen.

Mit dem beschriebenen MODFET ist eine Grenzfrequenz von ungefähr 10 GHz erreichbar.

Die Erfindung ist nicht auf das beschriebene Ausführungsbeispiel beschränkt, sondern sinngemäß auf weitere anwendbar. Beispielsweise ist es möglich, einen n-leitenden Kanal dadurch zu erzeugen, daß die mit den Bezugszeichen 3, 4 bezeichnete Schichtenfolge mehrmals wiederholt wird, so daß z.B. eine sogenannte Doppel- oder Multi-Heterostruktur entsteht. Weiterhin ist es möglich, für die Kontaktierungsschicht 8 eine wenig dotierte Si-Schicht zu verwenden, die ebenfalls einen ausreichenden Schottky-Kontakt 9 ermöglicht.

**Ansprüche**

1. Modulationsdotierter Feldeffekttransistor, bestehend aus einem Siliziumsubstrat, auf dem eine modulationsdotierte Silizium-Germanium/Silizium-Schichtenfolge aufgebracht ist, mit mindestens einer Steuerelektrode, dadurch gekennzeichnet,
   - daß auf dem Siliziumsubstrat (1) eine Pufferschicht (2) aufgebracht ist, bestehend aus einer Silizium-Germanium-Legierung,
   - daß auf der Pufferschicht (2) eine undotierte Silizium-Schicht (3) aufgebracht ist,
   - daß auf der undotierten Silizium-Schicht (3) eine n-dotierte Silizium-Germanium-Schicht (4) aufgebracht ist, wodurch ein Heteroübergang (6) und ein n-leitender kanal gebildet werden,
   - daß die n-Dotierung (5) innerhalb der Silizium-Germanium-Schicht (4) räumlich begrenzt ist, wobei eine Berührung zwischen der n-Dotierung (5) und dem Heteroübergang (6) vermieden wird,
   - daß eine Silizium-Germanium-Übergangsschicht (7) auf den den n-leitenden Kanal bildenden Halbleiterschichten (3, 4, 5) aufgebracht ist, deren Germanium-Gehalt mit zunehmendem Abstand von dem n-leitenden Kanal abnimmt,
   - daß eine Kontaktierungsschicht (8), die aus undotiertem Silizium besteht, auf der Silizium-Germanium-Übergangsschicht (7) aufgebracht ist,
   - daß die Steuerelektrode (12), als Gate-Anschluß, an der Kontaktierungsschicht (8) einen Schottky-Kontakt (9) besitzt, und
   - daß die Source- und Drainanschlüsse (10, 11) auf der Kontaktierungsschicht (8) aufgebracht sind.

2. Modulationsdotierter Feldeffekttransistor nach Anspruch 1, dadurch gekennzeichnet, daß das Siliziumsubstrat (1) elektrisch hochohmig ausgebildet ist zur Vermeidung störender parasitärer elektrischer Effekte.

3. Modulationsdotierter Feldeffekttransistor nach Anspruch 1 oder Anspruch 2, dadurch gekennzeichnet,
   - daß in der Pufferschicht (2) ein Germanium-Anteil vorhanden ist, der größer als 20 Atomprozent ist, und
   - daß die Schichtdicke der Pufferschicht (2) so gewält ist, daß in der nachfolgend aufgebrachten Schichtenfolge eine vorherbestimmbare mechanische Spannungsverteilung entsteht.

4. Modulationsdotierter Feldeffekttransistor nach einem der vorhergehenden Ansprüche, dadurch gekennzeichnet, daß die den n-leitenden Kanal bildenden Halbleiterschichten (3, 4, 5) jeweils eine Schichtdicke besitzen, die kleiner als eine kritische Schichtdicke ist, so daß zusätzliche mechanische Spannungsdekekte vermieden werden.

5. Modulationsdotierter Feldeffekttransistor nach einem der vorhergehenden Ansprüche, dadurch gekennzeichnet, daß bei der n-dotierten SiliziumGermanium-Schicht (4) als Dotierungsmaterial Antimon verwendet ist.

6. Modulationsdotierter Feldeffekttransistor nach einem der vorhergehenden Ansprüche, dadurch gekennzeichnet, daß in der n-dotierten Silizium-Germanium-Schicht (4) ein Germanium-Anteil vorhanden ist, der größer als 20 Atomprozent ist.

7. Modulationsdotierter Feldeffekttransistor nach einem der vorhergehenden Ansprüche, dadurch gekennzeichnet, daß die Höhe des Leitungsbandsprunges (16) am Heteroübergang (6) einstellbar ist durch Wahl des Germanium-Anteiles in der Pufferschicht (2) und/oder den Germanium- enthaltenden Halbleiterschichten, welche den n-leitenden Kanal erzeugen.

8. Modulationsdotierter Feldeffekttransistor nach einem der vorhergehenden Ansprüche, dadurch gekennzeichnet, daß der Abstand zwischen dem Schottky-Kontakt (9) und dem n-leitenden Kanal einstellbar ist durch eine Verringerung der Schichtdicke der Kontaktierungsschicht (8) zumindest im Bereich des Schottky-Kontaktes (9).

**Claims**

1. Modulation-doped field effect transistor consisting of a silicon substrate, on which a modulation-doped silicon germanium/silicon layer sequence is applied, with at least one control electrode, characterised thereby, that,
   - that a buffer layer (2) consisting or a silicon-germanium alloy is applied on the silicon substrate (1),
   - that an undoped silicon layer (3) is applied on the buffer layer (2),
   - that an n-doped silicon-germanium layer (4) is applied on the undoped silicon layer (3), whereby a heterotransition (6) and an n-conducting channel are formed,
   - that the n-doping (5) within the silicon-germanium layer (4) is spatially limited, whereby a touching between the n-doping (5) and the heterotransition (6) is avoided,
   - that a silicon-germanium transition layer (7) is applied on the semiconductor layers (3, 4, 5) forming the n-conducting channel, the germanium content of which layer reduces with increasing distance from the n-conducting channel,
   - that a contact-making layer (8), which consists of undoped silicon, is applied on the silicon-germanium transition layer (7),
   - that the control electrode (12) as gate connection possesses a Schottky contact (9) at the contact-making layer (8) and
   - that the source and drain connections (10, 11) are applied on the contact-making layer (8).

2. Modulation-doped field effect transistor according to claim 1, characterised thereby, that the silicon substrate (1) is constructed to be electrically of high resistance for the avoidance of interfering parasitic electrical effects.

3. Modulation-doped field effect transistor according to claim 1 or 2, characterised thereby,
   - that a germanium constituent, which is greater than 20 atom %, is present in the buffer layer (2) and
   - that the layer thickness of the buffer layer (2) is so chosen that a predeterminable mechanical stress distribution arises in the subsequently applied layer sequence.

4. Modulation-doped field effect transistor according to one of the preceding claims, characterised thereby, that the semiconductor layers (3, 4, 5) forming the n-conducting channel each possess a respective layer thickness which is smaller than a critical layer thickness so that additional mechanical stress defects are avoided.

5. Modulation-doped field effect transistor according to one of the preceding claims, characterised thereby, that antimony is used as doping material for the n-doped silicon-germanium layer (4).

6. Modulation-doped field effect transistor according to one of the preceding claims, characterised thereby, that a germanium constituent, which is greater than 20 atom % is present in the n-doped silicon-germanium layer (4).

7. Modulation-doped field effect transistor according to one of the preceding claims, characterised thereby, that the height of the conduction band step (16) at the hetertransition (6) is adjustable by choice of the germanium constituent in the buffer layer (2) and/or the semiconductor layers which contain germanium and produce the n-conducting channel.

8. Modulation-doped field effect transistor according to one of the preceding claims, characterised thereby, that the spacing between the Schottky contact (9) and the n-conducting channel is adjustable by reduction in the layer thickness of the contact-making layer (8) at least in the region of the Schottky contact (9).

**Revendications**

1. Transistor à effet de champ à dopage modulé, constitué d'un substrat de silicium sur lequel est rapportée une succession de couches silicium-germanium/silicium à dopage modulé, comportant au moins une électrode de commande, caractérisé

- par le fait que sur le substrat de silicium (1) est rapportée une couche tampon (2) constituée d'un alliage silicium-germanium,
- par le fait que sur la couche tampon (2) est rapportée une couche de silicium non dopé (3),
- par le fait que sur la couche de silicium non dopé (3) est rapportée une couche silicium-germanium (4) dopée de type n, ce par quoi se forment une hétérotransition (6) et un canal à conduction n,
- par le fait que le dopage n (5) est limité dans l'espace à l'intérieur de la couche silicium-germanium (4), ce qui évite un contact entre le dopage n (5) et l'hétérotransition (6),
- par le fait que sur les couches semi-conductrices (3, 4, 5) qui forment le canal à conduction n est rapportée une couche de transition silicium-germanium (7) dont la teneur en germanium décroît lorsque la distance au canal à conduction n croît,
- par la fait qu'une couche de mise en contact (8), constituée de silicium non dopé, est rapportée sur la couche de transition silicium-germanium (7),
- par le fait que l'électrode de commande (12), en tant que borne de grille, possède à la couche de mise en contact (8) un contact Schottky (9) et
- par le fait que les bornes de source et de drain (10, 11) sont rapportées sur la couche de mise en contact (8).

2. Transistor à effet de champ à dopage modulé selon la revendication 1, caractérisé par le fait que le substrat de silicium (1) est prévu avec une résistance électrique élevée pour éviter des effets électriques parasites gênants.

3. Transistor à effet de champ à dopage modulé selon la revendication 1 ou la revendication 2, caractérisé

- par le fait que dans la couche tampon (2) se trouve une proportion de germanium supérieure à 20 atomes pour cent, et
- par le fait que l'épaisseur de la couche tampon (2) est choisie de façon à faire apparaitre une répartition prévisible de la contrainte mécanique dans la sucession de couches rapportées successivement.

4. Transistor à effet de champ à dopage modulé selon l'une des revendications précédentes, caractérisé par le fait que les couches semi-conductrices (3, 4, 5) qui forment le canal à conduction n présentent chacune une épaisseur de couche qui est inférieure à une épaisseur de couche critique de façon à éviter des défauts supplémentaires résultant de la contrainte mécanique.

5. Transistor à effet de champ à dopage modulé selon l'une des revendications précédentes, caractérisé par le fait que dans le cas de la couche silicium-germanium (4) dopée de type n, on emploie comme matériau dopant de l'antimoine.

6. Transistor à effet de champ à dopage modulé selon l'une des revendications précédentes, caractérisé par le fait que dans la couche silicium-germanium (4) dopée de type n il existe une proportion de germanium supérieure à 20 atomes pour cent.

7. Transistor à effet de champ à dopage modulé selon l'une des revendications précédentes, caractérisé par le fait que l'on peut intervenir sur la hauteur du saut (16) de la bande de conduction à l'hétérotransition (6) par le choix de la proportion de germanium dans la couche tampon (2) et/ou dans les couches semi-conductrices contenant du germanium qui produisent le canal à conduction n.

8. Transistor à effet de champ à dopage modulé selon l'une des revendications précédentes, caractérisé par le fait que l'on peut intervenir sur la distance entre le contact Schottky (9) et le canal à conduction n en diminuant l'épaisseur de la couche de mise en contact (8) au moins dans la zone du contact Schottky (9).

FIG. 1

FIG. 2